# FASCICULE DE BREVET EUROPEEN

(11) **EP 4 022 687 B1**
(45) Date de publication et mention de la délivrance du brevet: **06.12.2023**
(21) Numéro de dépôt: 20807828.7
(22) Date de dépôt: 27.10.2020
(51) Int. Cl.: H01L 31/0224, H01L 31/078, H01L 31/068

(54) **PROCÉDÉ DE RÉALISATION D'UNE JONCTION TUNNEL D'UNE CELLULE PHOTOVOLTAÏQUE**
VERFAHREN ZUR HERSTELLUNG EINES TUNNELÜBERGANGS FÜR EINE FOTOVOLTAIKZELLE
METHOD FOR PRODUCING A TUNNEL JUNCTION FOR A PHOTOVOLTAIC CELL

(30) Priorité: 08.11.2019 FR 1912559
(43) Date de publication de la demande: 06.07.2022
(73) Titulaire: Commissariat à l'énergie atomique et aux énergies alternatives, 75015 Paris (FR)
(72) Inventeur: BELLANGER, Pierre, 38054 GRENOBLE CEDEX 09 (FR); DUBOIS, Sébastien, 38054 GRENOBLE CEDEX 09 (FR); SERON, Charles, 38054 GRENOBLE CEDEX 09 (FR)
(74) Mandataire: Brevalex
(86) Numéro de dépôt international: PCT/FR2020/051935
(87) Numéro de publication internationale: WO 2021/089927

(56) Documents cités:
- WO-A1-2019/059772
- CN-U- 209 232 797
- PEIBST ROBBY ET AL: "From PERC to Tandem: POLO- and p+/n+ Poly-Si Tunneling Junction as Interface Between Bottom and Top Cell", IEEE JOURNAL OF PHOTOVOLTAICS, I E E E, US, vol. 9, no. 1, 13 novembre 2018 (2018-11-13), pages 49-54, XP011694435, ISSN: 2156-3381, DOI: 10.1109/JPHOTOV.2018.2876999 [extrait le 2018-12-21]

## Description

### DOMAINE TECHNIQUE

La présente invention concerne le domaine de l'industrie photovoltaïque et plus particulièrement celui des cellules photovoltaïques.

Notamment, l'invention propose un procédé de formation d'une jonction tunnel d'une cellule photovoltaïque simple ou multi-jonction.

L'invention propose également une cellule photovoltaïque pourvue d'une jonction tunnel susceptible d'être obtenue par le procédé selon la présente invention.

### ÉTAT DE LA TECHNIQUE ANTÉRIEURE

Les cellules photovoltaïques multi-jonction (ci-après « cellule multi-jonction ») monolithiques à deux terminaux, et plus particulièrement les cellules tandem, sont formées d'un empilement de sous-cellules photovoltaïques (ci-après « sous-cellule ») absorbant dans des domaines spectraux différents de manière à améliorer le rendement de conversion photovoltaïque par rapport aux sous-cellules photovoltaïques considérées de manière individuelle.

Ces cellules multi-jonctions monolithiques à deux terminaux mettent généralement en oeuvre des jonctions tunnels intercalées entre les sous-cellules, qui permettent le transport des charges d'une sous-cellule à l'autre.

Ces jonctions tunnels sont également avantageusement mises en oeuvre pour la formation des contacts métalliques terminaux aussi bien des cellules multi-jonction que des cellules simple jonction.

En effet, en l'absence de jonction tunnel, une résistance électrique élevée peut parfois être observée à l'interface entre le contact métallique et la cellule photovoltaïque.

L'amplitude de cette résistance électrique peut notamment dépendre du métal formant le contact métallique ainsi que du type de dopage de la couche de la cellule sur laquelle ledit contact est réalisé.

Le positionnement d'une jonction tunnel entre la cellule ou la sous-cellule et le contact métallique permet alors de choisir et/ou ajuster le type de dopage effectivement vu par le contact métallique.

Les procédés de fabrication de jonctions tunnels connus de l'état de la technique peuvent impliquer l'épitaxie en phase liquide, l'épitaxie par jets moléculaires, le recuit rapide de solutions dopantes, l'élaboration de couches poly cristallines et le recuit rapide d'ions implantés par faisceau d'ions.

Les jonctions tunnel formées par épitaxie en phase liquide ou par jets moléculaires présentent des performances en conformité avec les requis de l'industrie photovoltaïque.

Cependant, les cadences et les coûts associés à ces techniques de fabrication sont autant de facteurs limitants pour la production industrielle des cellules photovoltaïques.

Le recuit rapide de solutions dopantes déposées à la surface de plaquettes c-Si, tel que décrit dans le document [1] cité à la fin de la description, permet la production de cellules à jonction tunnel inter-bandes à l'échelle industrielle.

Toutefois, ces techniques nécessitent d'exécuter un nombre important d'étapes.

En outre, les valeurs de rendement des cellules photovoltaïques associées à ces jonctions tunnel inter-bandes sont relativement faibles, et notamment ne dépassent pas les 10%.

Enfin, les solutions impliquées pour la formation de ces jonctions tunnel sont sources de contaminations des cellules photovoltaïques.

La formation de jonctions tunnel par implantation de dopants par faisceaux d'ions n'est pas non plus satisfaisante.

En effet, les implantations successives impliquées dans la formation de ces jonctions tunnel génèrent de nombreux défauts qui réduisent d'autant le rendement de la cellule photovoltaïque.

Le document [2] cité à la fin de la description divulgue également un procédé de formation d'une jonction tunnel qui comprend un empilement de deux couches de silicium poly cristallin présentant respectivement un dopage p++ et un dopage n++ sur une couche d'oxyde de silicium.

La couche de silicium poly cristallin de dopage n++ est formée par un procédé de recristallisation d'une couche de silicium dopée in situ déposée par LPCVD (Low Pressure Chemical Vapor Déposition). La couche de silicium poly cristallin de dopage p++ est directement obtenue par dépôt LPCVD à 650°C.

Cette technique implique le dépôt de couches de silicium amorphe ou poly cristallin sur les deux faces de la cellule photovoltaïque suivi du retrait de la ou des couches formées sur la face arrière.

Par ailleurs, les couches de silicium poly cristallin formées selon ce procédé sont relativement épaisses et absorbent donc en partie le rayonnement lumineux destiné à être converti en énergie électrique par la cellule photovoltaïque.

Le document CN 209 232 797 U divulgue un procédé de réalisation d'une jonction tunnel d'une cellule photovoltaïque comprenant une jonction PN formée sur un substrat en silicium, le procédé comprenant une étape de formation d'une première couche, une étape de formation d'une couche de matériau diélectrique, et une étape de formation d'une deuxième couche faite d'un matériau semi-conducteur polycristallin en recouvrement de la couche de matériau diélectrique.

Un but de la présente invention est donc de proposer un procédé de formation d'une jonction tunnel sur une cellule photovoltaïque ayant un impact limité sur le rendement de ladite cellule.

Un autre but de la présente invention est de proposer un procédé de formation d'une jonction tunnel qui permet de guérir/corriger les défauts de surface susceptibles d'être présents sur la surface de la cellule photovoltaïque sur laquelle est formée ladite jonction.

Un autre but de la présente invention est de proposer un procédé de formation d'une jonction tunnel plus simple à mettre en oeuvre sur le plan industriel.

### EXPOSÉ DE L'INVENTION

Les buts de la présente invention sont, au moins en partie, atteints par un procédé de réalisation d'une jonction tunnel d'une cellule photovoltaïque, la cellule photovoltaïque comprenant une jonction PN formée dans ou sur un substrat en silicium, la jonction tunnel étant réalisé sur une première face du substrat en silicium pourvue d'une seconde face opposée à la première face, la jonction tunnel comprenant un empilement formé par une première couche, une couche de matériau diélectrique et une deuxième couche, le procédé comprenant les étapes suivantes :
a) une étape de formation de la première couche, ladite formation comprenant l'implantation de premières espèces dopantes d'un premier type dans une région de la cellule photovoltaïque qui s'étend à partir de la première face ;
b) une étape de formation de la couche de matériau diélectrique sur la première face, d'une épaisseur inférieure à 5 nm, avantageusement inférieure à 2 nm ;
c) une étape de formation de la deuxième couche faite d'un matériau semi-conducteur amorphe ou poly cristallin en recouvrement de la couche de matériau diélectrique, et qui comprend des secondes espèces dopantes d'un second type différent du premier type ;
d) une étape de recuit destinée à induire la recristallisation de la deuxième couche et à activer les premières espèces dopantes ainsi que les secondes espèces dopantes.

Selon un mode de mise en oeuvre, l'étape a) d'implantation est réalisée par une technique d'implantation surfacique, la technique d'implantation surfacique comprend avantageusement une implantation par immersion plasma.

Selon un mode de mise en oeuvre, l'étape b) de formation de la couche de matériau diélectrique est exécutée selon l'une des techniques choisie parmi : croissance en phase chimique, dépôt en phase chimique assisté par plasma, dépôt de couches atomiques, par oxydation thermique.

Selon un mode de mise en oeuvre, la couche de matériau diélectrique comprend un des matériaux choisi parmi : oxyde de silicium, alumine, nitrure de silicium, oxynitrure de silicium.

Selon un mode de mise en oeuvre, la deuxième couche présente une épaisseur comprise entre 5 nm et 50 nm, avantageusement comprise entre 5 nm et 30 nm.

Selon un mode de mise en oeuvre, l'étape c) de formation de la deuxième couche est exécutée par une technique de dépôt en phase chimique assistée par plasma.

Selon un autre mode de mise en oeuvre, l'étape c) de formation de la deuxième couche est exécutée par une technique de dépôt chimique en phase vapeur à basse pression (« Low Pressure Chemical Vapor Déposition » ou « LPCVD » selon la terminologie Anglo-Saxonne).

Selon un mode de mise en oeuvre, la teneur en secondes espèces dopantes est comprise entre 3×10¹⁹ at/cm³ et 3×10²¹ at/cm³.

Selon un mode de mise en oeuvre, le matériau semi-conducteur amorphe ou poly cristallin comprend au moins un des matériaux choisi parmi : silicium, carbure de silicium, ou un empilement d'une couche faite du matériau semi-conducteur amorphe ou cristallin et d'une couche d'oxyde de silicium.

Egalement la deuxième couche peut être constituée d'une première phase d'un matériau semi-conducteur amorphe ou poly cristallin et d'une seconde phase constituée d'oxyde de silicium.

Selon un mode de mise en oeuvre, une autre couche de matériau diélectrique, de même nature que la couche de matériau diélectrique, est formée sur la seconde face.

Selon un mode de mise en oeuvre, une troisième couche, de même nature que la deuxième couche, est formée sur la seconde face, le recuit exécuté à l'étape d) étant également destiné à induire la recristallisation de la troisième couche et à activer les secondes espèces dopantes qu'elle contient.

Selon un mode de mise en oeuvre, l'étape d) de recuit comprend une élévation de température à une température fixe comprise entre 750°C et 950°C, avantageusement comprise entre 800°C et 850°C.

Selon un mode de mise en oeuvre, l'étape d) comprend un recuit thermique rapide.

Selon un mode de mise en oeuvre, l'étape d) est exécutée selon une durée comprise entre 30 secondes et 60 min.

Selon un mode de mise en oeuvre, le procédé comprend en outre une étape e) de formation de contacts électriques sur la seconde face, la formation de contacts comprenant avantageusement une étape de métallisation de la seconde face.

Selon un mode de mise en oeuvre, le procédé comprend en outre une étape g) d'hydrogénation de la première interface formée entre la première couche et la couche de matériau diélectrique d'une part, et la deuxième interface formée entre la couche de matériau diélectrique et la deuxième couche d'autre part.

Selon un mode de mise en oeuvre, l'étape g) comprend la formation d'une couche de nitrure de silicium hydrogéné en recouvrement de la deuxième couche (13a) suivie d'une étape de traitement thermique destinée à faire diffuser l'hydrogène initialement dans la couche de nitrure de silicium vers la première interface et la deuxième interface, l'étape g) étant exécutée soit avant l'étape d) de sorte que l'étape de traitement thermique corresponde au recuit de l'étape d), soit après l'étape d) de sorte que l'étape de traitement thermique comprenne un recuit rapide.

Selon un mode de mise en oeuvre, le procédé comprend la formation d'une autre jonction PN en recouvrement de la jonction tunnel.

Selon un mode de mise en oeuvre, le niveau de dopage des premières espèces dopantes dans la première couche est supérieur à 3 × 10¹⁹ at.cm⁻³, voire supérieur à 5 × 10¹⁹ at.cm⁻³.

Selon un mode de mise en oeuvre, le niveau de dopage des deuxièmes espèces dopantes dans la deuxième couche est supérieur à 3 × 10¹⁹ at.cm⁻³, voire supérieur à 5 × 10¹⁹ at.cm⁻³.

L'invention concerne également une cellule photovoltaïque qui comprend une jonction PN formée sur ou dans un substrat en silicium, le substrat en silicium comprend une première face faite de silicium cristallin, et une seconde face opposée à la première face, la cellule photovoltaïque est également pourvu d'une jonction tunnel, la jonction tunnel comprenant :
- une première couche s'étend à partir de la première face faite de silicium cristallin et qui comprend des premières espèces dopantes, d'un premier type ;
- une couche de matériau diélectrique sur la première face, d'une épaisseur inférieure à 5 nm, avantageusement inférieure à 2 nm ;
- une deuxième couche faite d'un matériau semi-conducteur poly cristallin en recouvrement de la couche de matériau diélectrique, et qui comprend des secondes espèces dopantes d'un second type différent du premier type.

Selon un mode de mise en oeuvre, la cellule photovoltaïque comprend une autre jonction PN formée en recouvrement de la jonction tunnel.

Selon un mode de mise en oeuvre, un contact métallique est formé sur la deuxième couche.

### BRÈVE DESCRIPTION DES DESSINS

D'autres caractéristiques et avantages apparaîtront dans la description qui va suivre d'un procédé de formation d'une jonction tunnel, donnés à titre d'exemples non limitatifs, en référence aux dessins annexés dans lesquels :
La figure 1 est une représentation schématique de l'enchainement des étapes de fabrication d'une jonction tunnel selon la présente invention ;
La figure 2 est une représentation schématique de l'étape a) d'implantation surfacique mise en oeuvre de la cadre de la présente invention ;
La figure 3 est une représentation schématique de l'étape b) de formation de la couche de matériau diélectrique mise en oeuvre dans le cadre de la présente invention ;
La figure 4 est une représentation schématique de l'étape c) de formation de la deuxième couche mise en oeuvre dans le cadre de la présente invention ;
La figure 5 est une représentation schématique de l'étape e) de formation de contacts métalliques susceptible d'être mise en oeuvre dans le cadre de la présente invention ;
La figure 6 est une représentation graphique des profils d'implantation du bore par immersion plasma dans du silicium à différentes doses, l'axe vertical représente la concentration en bore (« C » en « at.cm⁻³) et l'axe horizontal représente la profondeur d'implantation (« D » en « nm »), les profils « a », « b » et « c » sont associés, respectivement, aux doses 5,9 × 10¹⁵ cm², 2,9 × 10¹⁵ cm² et 1,8 × 10¹⁵ cm² ;
La figure 7 est une représentation graphique des concentrations (axe vertical « C » en « at.cm⁻³ ») respectivement, de trous dans la deuxième couche (courbe « d ») et d'électrons dans la première couche (courbe « e ») en fonction de la profondeur (axe horizontal « D » en « nm »).

### EXPOSÉ DÉTAILLÉ DE MODES DE RÉALISATION PARTICULIERS

La présente invention concerne un procédé de fabrication cellule photovoltaïque qui comporte la réalisation d'une jonction tunnel sur une première face d'un substrat en silicium cristallin. Notamment, la jonction tunnel comprend un empilement formé par une première couche, une couche de matériau diélectrique et une deuxième couche.

La première couche est formée dans une région du substrat en silicium qui s'étend à partir de la première face par une technique d'implantation surfacique d'espèces dopantes d'un premier type.

Par « technique d'implantation surfacique », on entend une technique d'implantation qui permet de créer un profil d'implantation qui s'étend à partir de la première face, et décroissant en termes de concentration d'espèces implantées à partir de ladite première face.

Par « type d'espèces dopantes », on entend des espèces dopantes de type n (donneur d'électron(s)) ou de type p (accepteur d'électron(s)).

Selon la présente invention, par « substrat cristallin » on entend substrat monocristallin, substrat poly cristallin, substrat multi cristallin (à savoir qui comprend des grains colonnaires), substrat dans lequel coexistent des zones parfaitement monocristallines et des zones multi-cristallines.

La formation de la deuxième couche comprend le dépôt d'une couche d'un matériau amorphe ou poly cristallin dopé par des secondes espèces dopantes d'un second type différent du premier type.

Le procédé selon la présente invention comprend également une étape de recuit thermique permettant d'induire la recristallisation de la deuxième couche et à activer les premières espèces dopantes ainsi que les secondes espèces dopantes.

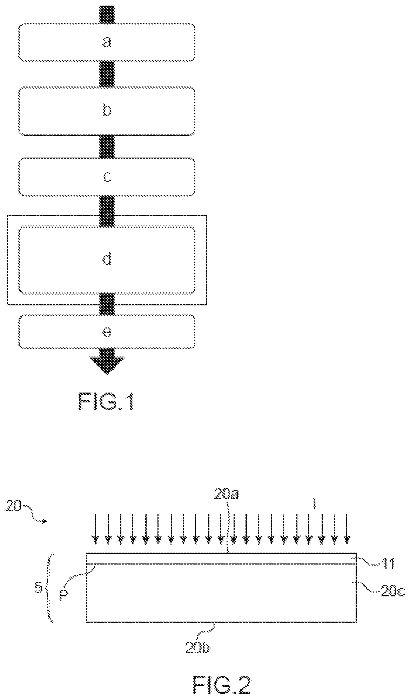

La figure 1 représente les différentes étapes du procédé de réalisation d'une jonction tunnel 10, d'une cellule photovoltaïque 5, sur une première face 20a d'un substrat en silicium 20.

Il est entendu que la cellule photovoltaïque 5 comprend au moins une jonction PN, formée dans ou sur le substrat de silicium, et associée à la jonction tunnel.

En particulier, la jonction tunnel selon les termes de la présente invention partage une interface avec la jonction PN.Le substrat en silicium 20 comprend également une seconde face 20b qui est reliée par un contour 20c à la première face 20a.

La cellule photovoltaïque 5 peut comprendre une pluralité de sous cellules empilées les unes sur les autres, ou être limitée à une seule sous-cellule.

La première face 20a du substrat en silicium 20 est faite de silicium cristallin. En d'autres termes, le substrat en silicium 20 comprend une couche, dite couche supérieure, faite de silicium cristallin et dont une face forme la première face 20a.

Le procédé selon la présente invention comprend une étape a) de formation d'une première couche 11 (figure 2).

L'étape a) comprend notamment l'implantation de premières espèces dopantes d'un premier type (I) dans une région de la cellule photovoltaïque 5 qui s'étend à partir de la première face 20a.

Cette première région délimitée par la première face 20a et la ligne pointillée (P) sur la figure 2 est destinée à former, une fois implantée, la première couche 11.

Les premières espèces dopantes peuvent être du type n ou de type p.

Selon un mode de réalisation avantageux, l'étape a) d'implantation peut être réalisée par une technique d'implantation surfacique.

Plus particulièrement, la technique d'implantation surfacique peut comprendre une implantation par immersion plasma.

Cette technique d'implantation permet d'obtenir un profil d'implantation décroissant des espèces dopantes à partir de la première face, et sur une épaisseur relativement faible, notamment inférieure à 200 nm, voire inférieure à 50 nm.

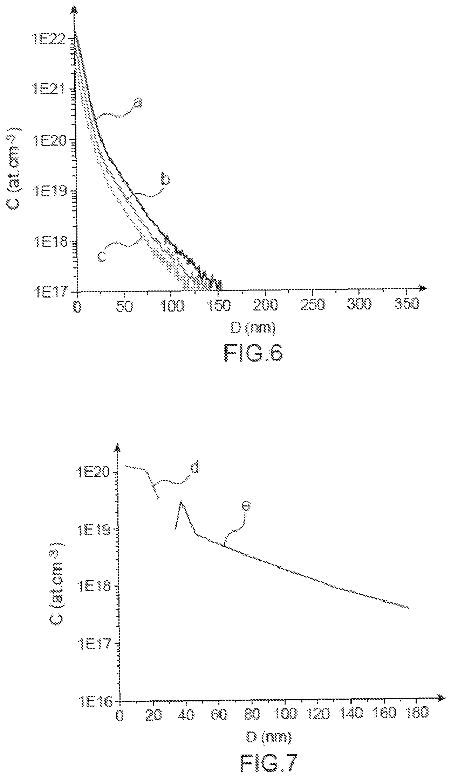

La figure 6 illustre à cet égard les profils d'implantation de bore dans du silicium obtenus par implantation par immersion plasma. Un profil décroissant de la teneur en bore est clairement observé à partir de la face implantée.

L'étape a) est suivie d'une étape b) de formation de la couche de matériau diélectrique 12a sur la première face 20a, d'une épaisseur inférieure à 5 nm, avantageusement inférieure à 2 nm.

La couche de matériau diélectrique 12a peut notamment être formée selon l'une des techniques choisie parmi : croissance en phase chimique, dépôt en phase chimique assisté par plasma, dépôt de couches atomiques, par oxydation thermique.

Par ailleurs, la couche de matériau diélectrique 12a peut comprendre un des matériaux choisi parmi : oxyde de silicium, alumine, nitrure de silicium, oxynitrure de silicium.

Une autre couche de matériau diélectrique 12b, de même nature que la couche de matériau diélectrique, peut être formée sur la seconde face 20b. Cette dernière dépendamment de l'application visée peut être conservée ou supprimée.

Cette autre couche de matériau diélectrique 12b peut par exemple être formée, lors de l'exécution de l'étape b), en même temps que la couche de matériau diélectrique 12a. Ceci est principalement le cas, si ces deux couches sont déposées par dépôt chimique en phase vapeur à basse pression.

Cette autre couche de matériau diélectrique 12b pourra notamment être conservée lors de l'établissement de contacts métalliques sur la seconde face 20b.

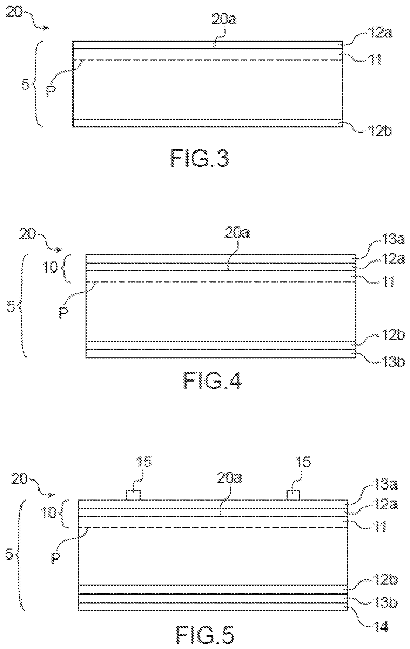

Le procédé selon la présente invention comprend également une étape c) de formation d'une deuxième couche 13a qui comprend un matériau semi-conducteur amorphe ou poly cristallin en recouvrement de la couche de matériau diélectrique 12a. La deuxième couche 13a comprend par ailleurs des secondes espèces dopantes d'un second type différent du premier type (figure 4).

Il est entendu que le dopage par les secondes espèces dopantes de la deuxième couche 13a est exécuté lors de l'étape de formation de ladite couche (dopage in situ).

L'étape c) de formation de la deuxième couche 13a peut être exécutée par une technique de dépôt en phase chimique assistée par plasma.

La teneur en secondes espèces dopantes dans la deuxième couche 13a peut être comprise entre 3×10¹⁹ at/cm³ et 3×10²¹ at/cm³.

De manière avantageuse, la deuxième couche 13a peut présenter une épaisseur comprise entre 5 nm et 50 nm, avantageusement comprise entre 5 nm et 30 nm.

Le matériau semi-conducteur amorphe ou poly cristallin formant la deuxième couche 13a peut comprendre au moins un des matériaux choisi parmi : silicium, carbure de silicium.

De manière alternative ou complémentaire, la deuxième couche 13a peut être constituée d'une première phase d'un matériau semi-conducteur amorphe ou poly cristallin et d'une seconde phase constituée d'oxyde de silicium.

Une troisième couche 13b, de même nature que la deuxième couche 13a, peut être formée sur la seconde face ou en recouvrement de l'autre couche de matériau diélectrique 12b.

Cette troisième couche 13b peut par exemple être formée, lors de l'exécution de l'étape c), en même temps que la deuxième couche 13a. Ceci est principalement le cas, si ces deux couches sont déposées par dépôt chimique en phase vapeur à basse pression.

La troisième couche 13b, dépendamment de l'application visée, peut être conservée ou supprimée.

L'établissement de contacts métalliques sur la seconde face 20b, décrite dans la suite de l'énoncé, pourra nécessiter la conservation de la troisième couche 13b.

Le procédé selon la présente invention comprend également une étape d) de recuit destinée à induire la recristallisation de la deuxième couche 13a et à activer les premières espèces dopantes ainsi que les secondes espèces dopantes.

Il est à cet égard notable que cette unique étape de recuit qui permet à la fois d'activer des espèces dopantes et de recristalliser une couche de matériau semi-conducteur amorphe ou poly cristallin permet de simplifier considérablement le procédé de fabrication de la jonction tunnel. Par ailleurs, le budget thermique imposé à la cellule photovoltaïque 5 s'en trouve réduit.

Si la deuxième couche 13a est amorphe à l'issue du dépôt, l'étape de recristallisation de la deuxième couche 13a transforme le matériau semi-conducteur amorphe en matériau semi-conducteur poly cristallin.

Si la troisième couche 13b est conservée, le recuit exécuté à l'étape d) permet également d'induire la recristallisation de cette dernière si celle-ci est initialement amorphe, et d'activer les secondes espèces dopantes qu'elle contient.

L'étape d) de recuit peut comprendre une élévation de température à une température fixe comprise entre 750°C et 950°C, avantageusement comprise entre 800°C et 850°C.

L'étape d) peut être un recuit thermique rapide.

L'étape d) peut être est exécutée selon une durée comprise entre 30 secondes et 60 min.

Le procédé selon la présente invention peut également comprendre une étape e) de formation de contacts électriques 14 sur la seconde face 20b (figure 5).

Notamment, les contacts électriques peuvent être formés sur la troisième couche 13b.

La formation de contacts métalliques peut comprendre une étape de métallisation de la seconde face.

Le procédé selon la présente invention peut également comprendre une étape f) de formation de contacts électriques 15 sur la deuxième couche 13a (figure 5).

La formation de contacts métalliques peut comprendre une étape de métallisation de la face exposée de la deuxième couche 13a avec une électrode de grille.

De manière optionnelle, le procédé peut comprendre une étape g) d'hydrogénation de la première interface formée entre la première couche 11 et la couche de matériau diélectrique 12a d'une part, et la deuxième interface formée entre la couche de matériau diélectrique 12a et la deuxième couche 13a d'autre part.

L'étape g) peut à cet égard comprendre la formation d'une couche de nitrure de silicium hydrogéné en recouvrement de la deuxième couche 13a avant exécution de l'étape d). Le recuit de l'étape d) est alors également destiné à faire diffuser l'hydrogène dans la couche de nitrure de silicium vers la première interface et la deuxième interface.

Selon un autre mode de mise en oeuvre, l'étape g) comprend la formation d'une couche de nitrure de silicium hydrogéné en recouvrement de la deuxième couche 13a après le recuit de l'étape d). L'étape g) peut alors avantageusement être suivie d'une étape de recuit rapide destinée à faire diffuser l'hydrogène initialement dans la couche de nitrure de silicium vers la première interface et la deuxième interface.

À l'issue de ce procédé, la jonction tunnel 10 est formée sur la cellule photovoltaïque 5.

La jonction tunnel est obtenue par :
- la première couche 11, dopée avec les premières espèces
- la couche de matériau diélectrique
- la seconde couche recristallisée et dopée avec les secondes espèces.

Les couches qui ont permis d'obtenir cette jonction tunnel, dans la mesure où l'épaisseur de la seconde couche poly-cristalline est relativement faible au regard des couches poly-cristallines considérées dans le document [2] cité à la fin de la description, permettent une absorption plus faible du rayonnement lumineux par les couches permettant d'obtenir ladite jonction, et par voie de conséquence une amélioration du rendement de la cellule considérée.

Par ailleurs, la combinaison d'un dopage par une étape a) d'implantation surfacique et d'un recuit thermique rapide permet d'obtenir un profil de concentration en espèces dopantes activées relativement abrupt.

Cette combinaison permet également de considérer des niveaux de dopage (concentrations en porteurs libres majoritaires) de la première couche 11 supérieurs à 3 × 10¹⁹ at.cm⁻³, voire supérieurs à 5 × 10¹⁹ at.cm⁻³.

Toujours de manière avantageuse, le niveau de dopage des deuxièmes espèces dopantes dans la deuxième couche 13a peut être supérieur à 3 × 10¹⁹ at.cm⁻³, voire supérieur à 5 × 10¹⁹ at.cm⁻³.

Les inventeurs ont caractérisé les propriétés électriques d'une cellule photovoltaïque 5 pourvue d'une jonction tunnel formée selon la présente invention et qui comprend :
- une première couche formée de silicium monocristallin et dopée avec du phosphore ;
- une couche de matériau diélectrique faite de dioxyde de silicium ;
- une deuxième couche de silicium poly cristallin dopée avec du bore.

Dans le cadre de cette caractérisation, l'étape de recuit d) a été exécutée à une température de 800 °C et sur une durée de 30 minutes.

Les profils de concentration en charges libres majoritaires sont représentés de manière graphique sur la figure 7. Notamment, le profil « d » représente la concentration en trous dans la deuxième couche en fonction de la profondeur dans ladite deuxième couche, et le profil « e » représente la concentration en électrons dans la première couche en fonction de la profondeur dans ladite première couche.

Le tableau donné ci-dessous regroupe les performances d'une cellule photovoltaïque 5 pourvue de la jonction tunnel décrite ci-avant :

| J_{sc} (mA/cm²) | Voc (mV) | FF (%) | η (%) |
|---|---|---|---|
| 28.5 | 484.5 | 41.5 | 5.7 |

Les niveaux de courant, de tension, et de rendement atteints attestent du caractère fonctionnel de la structure élaborée.

En particulier, contre toute attente, la considération de la couche de matériau diélectrique n'affecte pas tant le fonctionnement de la jonction tunnel que les performances de la cellule photovoltaïque.

Par ailleurs, la couche de matériau diélectrique permet également de guérir les défauts susceptibles d'être présents sur la première face (passivation de cette dernière).

La formation de la jonction tunnel peut être suivie de la formation d'une autre cellule photovoltaïque en recouvrement de la jonction tunnel.

L'invention concerne également une cellule photovoltaïque comprenant une première face faite de silicium monocristallin, et une seconde face opposée à la première face, la cellule comprenant une jonction tunnel, la jonction tunnel comprenant :
- une première couche s'étend à partir de la première face faite de silicium monocristallin et qui comprend des premières espèces dopantes, d'un premier type ;
- une couche de matériau diélectrique sur la première face, d'une épaisseur inférieure à 5 nm, avantageusement inférieure à 2 nm ;
- une deuxième couche faite d'un matériau semi-conducteur cristallin en recouvrement de la couche de matériau diélectrique, et qui comprend des secondes espèces dopantes d'un second type différent du premier type.

Une deuxième cellule photovoltaïque en recouvrement de la jonction tunnel peut également être considérée.

Par ailleurs, la cellule photovoltaïque peut également comprendre un contact métallique formé sur la deuxième couche.

### RÉFÉRENCES

[1] A. Fave & al., Fabrication of Si tunnel diodes for c-Si based tandem solar cells using proximity rapid thermal diffusion, Energy Procedia 124, 577-583, 2017 ;
[2] R. Peibst & al., From PERC to Tandem: POLO- and p+/n+ Poly-Si Tunneling Junction as Interface Between Bottom and Top Cell, IEEE Journal of Photovoltaics PP(99):1-6, 2018.

## Revendications

1. Procédé de réalisation d'une jonction tunnel (10) d'une cellule photovoltaïque (5), la cellule photovoltaïque (5) comprenant une jonction PN formée dans ou sur un substrat en silicium (20), la jonction tunnel (10) étant réalisé sur une première face (20a) du substrat en silicium (20) pourvu d'une seconde face (20b) opposée à la première face (20a), la jonction tunnel (10) comprenant un empilement formé par une première couche (11), une couche de matériau diélectrique (12a) et une deuxième couche (13a), le procédé comprenant les étapes suivantes :
a) une étape de formation de la première couche (11), ladite formation comprenant l'implantation de premières espèces dopantes d'un premier type dans une région du substrat en silicium (20) qui s'étend à partir de la première face (20a) ;
b) une étape de formation de la couche de matériau diélectrique (12a) sur la première face (20a), d'une épaisseur inférieure à 5 nm, avantageusement inférieure à 2 nm ;
c) une étape de formation de la deuxième couche (13a) faite d'un matériau semi-conducteur amorphe ou poly cristallin en recouvrement de la couche de matériau diélectrique (12a), et qui comprend des secondes espèces dopantes d'un second type différent du premier type ;
d) une étape de recuit destinée à induire la recristallisation de la deuxième couche (13a) et à activer les premières espèces dopantes ainsi que les secondes espèces dopantes.

2. Procédé selon la revendication 1, dans lequel l'étape a) d'implantation est réalisée par une technique d'implantation surfacique, la technique d'implantation surfacique comprend avantageusement une implantation par immersion plasma.

3. Procédé selon la revendication 1 ou 2, dans lequel l'étape b) de formation de la couche de matériau diélectrique (12a) est exécutée selon l'une des techniques choisie parmi : croissance en phase chimique, dépôt en phase chimique assisté par plasma, dépôt de couches atomiques, par oxydation thermique.

4. Procédé selon l'une des revendications 1 à 3, dans lequel la couche de matériau diélectrique (12a) comprend un des matériaux choisi parmi : oxyde de silicium, alumine, nitrure de silicium, oxynitrure de silicium.

5. Procédé selon l'une de revendications 1 à 4, dans lequel la deuxième couche (13a) présente une épaisseur comprise entre 5 nm et 50 nm, avantageusement comprise entre 5 nm et 30 nm.

6. Procédé selon l'une des revendications 1 à 5, dans lequel l'étape c) de formation de la deuxième couche (13a) est exécutée par une technique de dépôt en phase chimique assistée par plasma ou par dépôt chimique en phase vapeur à basse pression.

7. Procédé selon l'une des revendications 1 à 6, dans lequel le niveau de dopage en secondes espèces dopantes dans la deuxième couche (13a) est compris entre 3×10¹⁹ at/cm³ et 3×10²¹ at/cm³.

8. Procédé selon l'une des revendications 1 à 7, dans lequel le matériau semi-conducteur amorphe ou poly cristallin comprend au moins un des matériaux choisi parmi : silicium, carbure de silicium.

9. Procédé selon l'une des revendications 1 à 7, dans lequel la deuxième couche 13a est constituée d'une première phase d'un matériau semi-conducteur amorphe ou poly cristallin et d'une seconde phase constituée d'oxyde de silicium SiOₓ.

10. Procédé selon l'une des revendications 1 à 9, dans lequel une autre couche de matériau diélectrique (12b), de même nature que la couche de matériau diélectrique (12a), est formée sur la seconde face (20b).

11. Procédé selon l'une des revendications 1 à 10, dans lequel une troisième couche (13b), de même nature que la deuxième couche (13a), est formée sur la seconde face (20b), le recuit exécuté à l'étape d) étant également destiné à induire la recristallisation de la troisième couche (13b) et à activer les secondes espèces dopantes qu'elle contient.

12. Procédé selon l'une des revendications 1 à 11, dans lequel l'étape d) de recuit comprend une élévation de température à une température fixe comprise entre 750°C et 950°C, avantageusement comprise entre 800°C et 850°C.

13. Procédé selon l'une des revendications 1 à 12, dans lequel l'étape d) comprend un recuit thermique rapide.

14. Procédé selon l'une des revendications 1 à 13, dans lequel l'étape d) est exécutée selon une durée comprise entre 30 secondes et 60 min.

15. Procédé selon l'une des revendications 1 à 14, dans lequel le procédé comprend en outre une étape g) d'hydrogénation de la première interface formée entre la première couche (11) et la couche de matériau diélectrique (12a) d'une part, et la deuxième interface formée entre la couche de matériau diélectrique (12a) et la deuxième couche (13a) d'autre part.

16. Procédé selon la revendication 15, dans lequel l'étape g) comprend la formation d'une couche de nitrure de silicium hydrogéné en recouvrement de la deuxième couche (13a) suivie d'une étape de traitement thermique destinée à faire diffuser l'hydrogène dans la couche de nitrure de silicium vers la première interface et la deuxième interface, l'étape g) étant exécutée soit avant l'étape d) de sorte que l'étape de traitement thermique corresponde au recuit de l'étape d), soit après l'étape d) de sorte que l'étape de traitement thermique comprenne un recuit rapide.

17. Procédé selon l'une des revendications 1 à 16, dans lequel le procédé comprend la formation d'une autre jonction PN en recouvrement de la jonction tunnel (10).

18. Procédé selon l'une des revendications 1 à 17, dans lequel le niveau de dopage des premières espèces dopantes dans la première couche (11) est supérieur à 3 × 10¹⁹ at.cm⁻³, voire supérieur à 5 × 10¹⁹ at.cm⁻³.

19. Procédé selon l'une des revendications 1 à 18, dans lequel le niveau de dopage des deuxièmes espèces dopantes dans la deuxième couche (13a) est supérieur à 3 × 10¹⁹ at.cm⁻³, voire supérieur à 5 × 10¹⁹ at.cm⁻³.

20. Cellule photovoltaïque (5) qui comprend une jonction PN formée sur ou dans un substrat en silicium (20), le substrat en silicium comprend une première face (20a) faite de silicium cristallin, et une seconde face (20b) opposée à la première face (20a), la cellule photovoltaïque (5) est également pourvu d'une jonction tunnel (10), la jonction tunnel (10) comprenant :
- une première couche (11) s'étend à partir de la première face (20a) faite de silicium cristallin et qui comprend des premières espèces dopantes, d'un premier type ;
- une couche de matériau diélectrique (12a) sur la première face (20a), d'une épaisseur inférieure à 5 nm, avantageusement inférieure à 2 nm ;
- une deuxième couche (13a) faite d'un matériau semi-conducteur poly cristallin en recouvrement de la couche de matériau diélectrique (12a),
**caractérisée en ce que** la deuxième couche comprend des secondes espèces dopantes d'un second type différent du premier type.

21. Cellule selon la revendication 20, dans laquelle la cellule photovoltaïque comprend une autre jonction PN formée en recouvrement de la jonction tunnel (10).

22. Cellule selon la revendication 20, dans laquelle un contact métallique est formé sur la deuxième couche (13a).

## Patentansprüche

1. Verfahren zur Herstellung eines Tunnelübergangs (10) einer Fotovoltaik-Zelle (5), wobei die Fotovoltaik-Zelle (5) einen Übergang PN umfasst, der in oder auf einem Substrat aus Silizium (20) gebildet ist, wobei der Tunnelübergang (10) auf einer ersten Fläche (20a) des Substrats aus Silizium (20) hergestellt wird, das mit einer zweiten Fläche (20b), entgegengesetzt zur ersten Fläche (20a), versehen ist, wobei der Tunnelübergang (10) eine Stapelung umfasst, die durch eine erste Schicht (11), eine Schicht aus dielektrischem Werkstoff (12a) und einer zweiten Schicht (13a) gebildet ist, wobei das Verfahren die folgenden Schritte umfasst:
a) einen Schritt zum Bilden der ersten Schicht (11), wobei das Bilden das Einpflanzen erster Dotierstofftypen einer ersten Art in einer Region des Substrats aus Silizium (20) umfasst, die sich aus der ersten Fläche (20a) heraus erstreckt;
b) einen Schritt zum Bilden der Schicht aus dielektrischem Werkstoff (12a) auf der ersten Fläche (20a), mit einer Dicke von weniger als 5 nm, vorteilhafterweise weniger als 2 nm;
c) einen Schritt zum Bilden der zweiten Schicht (13a) aus einem amorphen oder polykristallinen Halbleiterwerkstoff zum Abdecken der Schicht aus dielektrischem Werkstoff (12a), und die zweite Dotierstofftypen einer zweiten Art, die sich von der ersten Art unterscheidet, umfasst;
d) einen Schritt des Glühens, der dazu bestimmt ist, die Umkristallisierung der zweiten Schicht (13a) zu veranlassen, und die ersten Dotierstofftypen, sowie die zweiten Dotierstofftypen zu aktivieren.

2. Verfahren nach Anspruch 1, wobei der Schritt a) des Einpflanzens durch eine Oberflächeneinpflanzungstechnik ausgeführt wird, wobei die Oberflächeneinpflanzungstechnik vorteilhafterweise eine Einpflanzung durch Plasma-Immersion umgesetzt wird.

3. Verfahren nach Anspruch 1 oder 2, wobei der Schritt b) des Bildens der der Schicht aus dielektrischem Werkstoff (12a) gemäß einer der Techniken ausgeführt wird, die ausgewählt sind aus: Wachstum aus chemischer Phase, Plasma-unterstütze chemische Phasenabscheidung, Atomschichtabscheidung, durch thermische Oxidation.

4. Verfahren nach einem der Ansprüche 1 bis 3, wobei die Schicht aus dielektrischem Werkstoff (12a) einen der Werkstoffe umfasst, die ausgewählt sind aus: Siliziumoxid, Aluminiumoxid, Siliziumnitrid, Siliziumoxynitrid.

5. Verfahren nach einem der Ansprüche 1 bis 4, wobei die zweite Schicht (13a) eine Dicke aufweist, die zwischen 5 nm und 50 nm, vorteilhafterweise zwischen 5 nm und 30 nm liegt.

6. Verfahren nach einem der Ansprüche 1 bis 5, wobei der Schritt c) des Bildens der zweiten Schicht (13a) durch eine Technik der Plasma-unterstützten chemischen Phasenabscheidung oder durch chemische Niederdruck-Gasphasenabscheidung umgesetzt wird.

7. Verfahren nach einem der Ansprüche 1 bis 6, wobei das Dotierungsniveau zweiter Dotierstofftypen in der zweiten Schicht (13a) zwischen 3×10¹⁹ at/cm³ und 3×10²¹ at/cm³ liegt.

8. Verfahren nach einem der Ansprüche 1 bis 7, wobei der amorphe oder polykristalline Halbleiterwerkstoff mindestens einen der Werkstoffe umfasst, der ausgewählt ist, aus: Silizium, Siliziumkarbid.

9. Verfahren nach einem der Ansprüche 1 bis 7, wobei die zweite Schicht (13a) aus einer ersten Phase eines amorphen oder polykristallinen Halbleiterwerkstoffs und einer zweiten Phase besteht, die aus Siliziumoxid SiOₓ gebildet ist.

10. Verfahren nach einem der Ansprüche 1 bis 9, wobei eine weitere Schicht aus dielektrischem Werkstoff (12b) derselben Art wie die Schicht aus dielektrischem Werkstoff (12a) auf der zweiten Fläche (20b) gebildet ist.

11. Verfahren nach einem der Ansprüche 1 bis 10, wobei eine dritte Schicht (13b) derselben Art wie die zweite Schicht (13a) auf der zweiten Fläche (20b) gebildet ist, wobei das im Schritt d) ausgeführte Glühen auch dazu bestimmt ist, die Umkristallisierung der dritten Schicht (13b) zu veranlassen, und die zweiten Dotierstofftypen, die sie enthält, zu aktivieren.

12. Verfahren nach einem der Ansprüche 1 bis 11, wobei der Schritt d) des Glühens eine Temperaturerhöhung auf eine feststehende Temperatur umfasst, die zwischen 750°C und 950°C liegt, vorzugsweise zwischen 800°C und 850°C liegt.

13. Verfahren nach einem der Ansprüche 1 bis 12, wobei der Schritt d) ein rasches thermisches Anlassen umfasst.

14. Verfahren nach einem der Ansprüche 1 bis 13, wobei der Schritt d) gemäß einer Dauer ausgeführt wird, die zwischen 30 Sekunden und 60 Min. liegt.

15. Verfahren nach einem der Ansprüche 1 bis 14, wobei das Verfahren weiter einen Schritt g) des Hydrierens der ersten Schnittstelle umfasst, die einerseits zwischen der ersten Schicht (11) und der Schicht aus dielektrischem Werkstoff (12a) gebildet wird, und der zweiten Schnittstelle, die andererseits zwischen der Schicht aus dielektrischem Werkstoff (12a) und der zweiten Schicht (13a) gebildet wird.

16. Verfahren nach Anspruch 15, wobei der Schritt g) die Bildung einer Schicht aus hydriertem Siliziumnitrid zur Überdeckung der zweiten Schicht (13a), gefolgt von einem Schritt zur thermischen Behandlung umfasst, der dazu bestimmt ist, den Wasserstoff in der Siliziumnitrid-Schicht zur ersten Schnittstelle und der zweiten Schnittstelle zu verbreiten, wobei der Schritt g) entweder vor dem Schritt d) derart ausgeführt wird, dass der Schritt zur thermischen Behandlung dem Glühen des Schrittes d) entspricht, oder nach dem Schritt d), sodass der Schritt zur thermischen Behandlung ein rasches Anlassen umfasst.

17. Verfahren nach einem der Ansprüche 1 bis 16, wobei das Verfahren das Bilden eines weiteren Übergangs PN als Überdeckung des Tunnelübergangs (10) umfasst.

18. Verfahren nach einem der Ansprüche 1 bis 17, wobei das Dotierungsniveau der ersten Dotierstofftypen in der ersten Schicht (11) größer als 3×10¹⁹ at.cm⁻³, oder gar größer als 5×10¹⁹ at.cm⁻³ ist.

19. Verfahren nach einem der Ansprüche 1 bis 18, wobei das Dotierungsniveau der zweiten Dotierstofftypen in der zweiten Schicht (13a) größer als 3×10¹⁹ at.cm⁻³ oder gar größer als 5×10¹⁹ at.cm⁻³ ist.

20. Fotovoltaik-Zelle (5), die einen Übergang PN umfasst, der in oder auf einem Substrat aus Silizium (20) gebildet ist, wobei das Substrat aus Silizium eine erste Fläche (20a) umfasst, die aus kristallinem Silizium gefertigt ist, und eine zweite Fläche (20b), entgegengesetzt zur ersten Fläche (20a), wobei die Fotovoltaik-Zelle (5) auch mit einem Tunnelübergang (10) versehen ist, wobei der Tunnelübergang (10) umfasst:
- eine erste Schicht (11), die sich aus der ersten Fläche (20a) heraus erstreckt, aus kristallinem Silizium gefertigt ist, und die erste Dotierstofftypen einer ersten Art umfasst;
- eine Schicht aus dielektrischem Werkstoff (12a) auf der ersten Fläche (20a) mit einer Dicke von weniger als 5 nm, vorteilhafterweise weniger als 2 nm;
- eine zweite Schicht (13a), die aus einem polykristallinen Halbleiterwerkstoff gefertigt ist, zur Überdeckung der Schicht aus dielektrischem Werkstoff (12a),
**dadurch gekennzeichnet, dass** die zweite Schicht zweite Dotierstofftypen einer zweiten Art, die sich von der ersten Art unterscheidet, umfasst.

21. Zelle nach Anspruch 20, wobei die Fotovoltaik-Zelle einen weiteren Übergang PN umfasst, der als Überdeckung des Tunnelübergangs (10) gebildet ist.

22. Zelle nach Anspruch 20, wobei ein metallischer Kontakt auf der zweiten Schicht (13a) gebildet ist.

## Claims

1. A method for making a tunnel junction (10) of a photovoltaic cell (5), the photovoltaic cell (5) comprising a PN junction formed in or over a silicon substrate (20), the tunnel junction (10) being made over a first face (20a) of the silicon substrate (20) provided with a second face (20b) opposite to the first face (20a), the tunnel junction (10) comprising a stack formed by a first layer (11), a dielectric material layer (12a) and a second layer (13a), the method comprising the following steps:
a) a step of forming the first layer (11), said formation comprising the implantation of first dopant species of a first type in a region of the silicon substrate (20) which extends from the first face (20a);
b) a step of forming the dielectric material layer (12a) over the first face (20a), with a thickness smaller than 5 nm, advantageously smaller 2 nm;
c) a step of forming the second layer (13a) made of an amorphous or polycrystalline semiconductor material overlapping the dielectric material layer (12a), and which comprises second dopant species of a second type different from the first type;
d) an annealing step intended to induce the recrystallisation of the second layer (13a) and to activate the first dopant species as well as the second dopant species.

2. The method according to claim 1, wherein the implantation step a) is carried out by a surface implantation technique, the surface implantation technique advantageously comprises implantation by plasma immersion.

3. The method according to claim 1 or 2, wherein step b) of forming the dielectric material layer (12a) is executed according to one of the techniques selected from among: chemical-phase growth, plasma-enhanced chemical-phase deposition, atomic layer deposition, by thermal oxidation.

4. The method according to one of claims 1 to 3, wherein the dielectric material layer (12a) comprises one of the materials selected from among: silicon oxide, alumina, silicon nitride, silicon oxynitride.

5. The method according to one of claims 1 to 4, wherein the second layer (13a) has a thickness comprised between 5 nm and 50 nm, advantageously comprised between 5 nm and 30 nm.

6. The method according to one of claims 1 to 5, wherein step c) of forming the second layer (13a) is executed by a plasma-enhanced chemical phase deposition technique or by low-pressure chemical vapor deposition.

7. The method according to one of claims 1 to 6, wherein the doping level of second dopant species in the second layer (13a) is comprised between 3×10¹⁹ at/cm⁻³ and 3×10²¹ at/cm⁻³.

8. The method according to one of claims 1 to 7, wherein the amorphous or polycrystalline semiconductor material comprises at least one of the materials selected from among: silicon, silicon carbide.

9. The method according to one of claims 1 to 7, wherein the second layer 13a consists of a first phase of an amorphous or polycrystalline semiconductor material and of a second phase consisting of silicon oxide SiOₓ.

10. The method according to one of claims 1 to 9, wherein another dielectric material layer (12b), of the same nature as the dielectric material layer (12a), is formed over the second face (20b).

11. The method according to one of claims 1 to 10, wherein a third layer (13b), of the same nature as the second layer (13a), is formed over the second face (20b), the annealing executed in step d) also being intended to induce the recrystallisation of the third layer (13b) and to activate the second dopant species it contains.

12. The method according to one of claims 1 to 11, wherein the annealing step d) comprises an increase in temperature to a set temperature comprised between 750°C and 950°C, advantageously between 800°C and 850°C.

13. The method according to one of claims 1 to 12, wherein step d) comprises rapid thermal annealing.

14. The method according to one of claims 1 to 13, wherein step d) is executed for a duration comprised between 30 seconds and 60 min.

15. The method according to one of claims 1 to 14, wherein the method further comprises a step g) of hydrogenating the first interface formed between the first layer (11) and the dielectric material layer (12a) on the one hand, and the second interface formed between the dielectric material layer (12a) and the second layer (13a) on the other hand.

16. The method according to claim 15, wherein step g) comprises forming a layer of hydrogenated silicon nitride overlapping the second layer (13a) followed by a heat treatment step intended to make the hydrogen diffuse in the silicon nitride layer towards the first interface and the second interface, step g) being executed either before step d) so that the heat treatment step corresponds to the annealing of step d), or after step d) so that the heat treatment step comprises a rapid annealing.

17. The method according to one of claims 1 to 16, wherein the method comprises forming another PN junction overlapping the tunnel junction (10).

18. The method according to one of claims 1 to 17, wherein the doping level of the first dopant species in the first layer (11) is greater than 3 × 10¹⁹ at/cm⁻³, and possibly greater than 5×10¹⁹ at/cm⁻³.

19. The method according to one of claims 1 to 18, wherein the doping level of the second dopant species in the second layer (13a) is greater than 3 × 10¹⁹ at/cm⁻³, and possibly greater than 5×10¹⁹ at/cm⁻³.

20. A photovoltaic cell (5) which comprises a PN junction formed over or in a silicon substrate (20), the silicon substrate comprises a first face (20a) made of crystalline silicon, and a second face (20b) opposite to the first face (20a), the photovoltaic cell (5) is also provided with a tunnel junction (10), the tunnel junction (10) comprising:
- a first layer (11) extends from the first face (20a) made of crystalline silicon and which comprises first dopant species, of a first type;
- a dielectric material layer (12a) over the first face (20a), with a thickness smaller than 5 nm, advantageously smaller than 2 nm;
- a second layer (13a) made of a polycrystalline semiconductor material overlapping the dielectric material layer (12a),
**characterised in that** the second layer comprises second dopant species of a second type different from the first type.

21. The cell according to claim 20, wherein the photovoltaic cell comprises another PN junction formed overlapping the tunnel junction (10).

22. The cell according to claim 20, wherein a metal contact is formed over the second layer (13a).
